# EUROPÄISCHE PATENTSCHRIFT

(11) **EP 0 725 412 B1**
(45) Veröffentlichungstag und Bekanntmachung des Hinweises auf die Patenterteilung: **04.04.2001**
(21) Anmeldenummer: 96100812.5
(22) Anmeldetag: 20.01.1996
(51) Int. Cl.: H01H 71/12, H01H 39/00, H01R 13/637, H01R 13/713

(54) **Sicherungsvorrichtung für eine Stromleitung in Fahrzeugen**
Safety device for a current line in vehicles
Dispositif de sécurité pour une ligne de courant dans des véhicules

(30) Priorität: 06.02.1995 DE 19503809
(43) Veröffentlichungstag der Anmeldung: 07.08.1996
(73) Patentinhaber: Bayerische Motoren Werke Aktiengesellschaft, 80788 München (DE)
(72) Erfinder: Albiez, Robert, D-85084 Reichertshofen (DE); Krappel, Alfred, D-85737 Ismaning (DE); Groebmair, Max, D-83623 Dietramszell (DE)

(56) Entgegenhaltungen:
- EP-A- 0 243 076
- DE-A- 4 413 847
- DE-C- 4 110 240
- FR-A- 1 434 280
- GB-A- 2 260 635

## Beschreibung

Die Erfindung bezieht sich auf eine Sicherungsvorrichtung nach dem Oberbegriff des Patentanspruchs 1.

Eine derartige Vorrichtung ist aus der DE 41 10 240 C bekannt. Sensor, Auswerteschaltung und Trennmittel sind räumlich voneinander getrennt. Der Sensor befindet sich über ein freies Stück der Stromleitung getrennt vom Trennmittel. Zwischen dem Sensor und der Auswerteschaltung einerseits und dieser und dem Trennmittel andererseits befinden sich jeweils separate Leitungen. Der Aufbau der bekannten Sicherungsvorrichtung ist daher aufwendig und besonders störanfällig, was sich gerade in dem besonders kritischen Fall eines Unfalls nachteilig bemerkbar machen kann. Die Verbindungsleitungen zwischen Sensor bzw. Trennmittel und Auswerteschaltung sind der Gefahr einer Beschädigung bzw. Zerstörung ausgesetzt. Dies kann zu einer Unwirksamkeit der bekannten Sicherungsvorrichtung gerade in dem angesprochenen kritischen Fall führen.

Der Erfindung liegt die Aufgabe zugrunde, eine Sicherungsvorrichtung der eingangs genannten Art zu schaffen, die sich durch einen einfachen Ausbau bei hoher Wirksamkeit auszeichnet.

Die Erfindung löst diese Aufgabe durch die Merkmale des Patentanspruchs 1.

Durch den kompakten Aufbau der Sicherungsvorrichtung besteht einerseits eine Zerstörungsgefahr insbesondere bei einem Unfall nicht. Gleichzeitig ergibt sich durch die Bauweise eine deutliche Verringerung wenn nicht sogar der vollständige Ausschluß von Funktionsstörungen auch und gerade bei einem Unfallgeschehen. Die Anordnung der Sicherungsvorrichtung ist an beliebiger Stelle, beispielsweise unmittelbar hinter oder integriert mit dem Batteriepluspol einer Fahrzeugbatterie oder aber auch unmittelbar hinter oder integriert mit einem Batteriestützpunkt möglich. Die kompakte Bauweise der Sicherungsvorrichtung wirkt sich auch auf der Kostenseite aus. Gegenüber der bekannten Sicherungsvorrichtung ergeben sich deutliche Kostenvorteile, die es ermöglichen, die Sicherungsvorrichtung auch mehrfach in einer Stromleitung zur Überwachung beispielsweise mehrerer besonders gefährdeter Leitungsabschnitte anzuordnen.

In den weiteren Patentansprüchen sind vorteilhafte Ausgestaltungen der Erfindung beschrieben. Sie zeichnen sich aus im Falle des Patentanspruchs
2. durch die weitere Verringerung des Leitungsaufwands
3. durch die Möglichkeit, nach dem Wirksamwerden des Trennmittels die Sicherungsvorrichtung auszutauschen, ohne hierfür umfangreiche Reparaturmaßnahmen an der Stromleitung vorzunehmen
4. durch die Möglichkeit, diese Reparatur besonders zeit- und kostengünstig durchzuführen
5. den gesamten konstruktiven Aufbau und damit den Fertigungsaufwand weiter zu verringern
6. durch die Mehrfachverwendung des Stromsensors eine weitere Kostenreduktion zu erzielen
7. eine weitere Möglichkeit die Sicherungsvorrichtung ohne großen Aufwand auszutauschen
8. durch die Möglichkeit, bei einer betriebsbedingt hohen Strombelastung das Wirksamwerden des Trennmittels zu verhindern (typischerweise bei Anlassen einer Brennkraftmaschine)
9. durch die Möglichkeit, die Auslöseschwelle für das Trennmittel den unterschiedlichen Strombelastungen der Stromleitung anzupassen.

Letzteres bietet vielfältige Möglichkeiten. So ist es nicht nur möglich, rasch aufeinanderfolgende Belastungsschwankungen zu berücksichtigen und die Auslöseschwelle für das Trennmittel rasch zu verändern. Es besteht auch die Möglichkeit, von Fahrzeug zu Fahrzeug verschiedene betriebsbedingte Strombelastungen zu berücksichtigen, die beispielsweise durch die Verwendung unterschiedlicher elektrischer Verbraucher bedingt sind. Auch besteht die Möglichkeit, eine Änderung der Strombelastung, wie sie im Langzeitbetrieb durch sich langsam ändernde elektrische Eigenschaften verschiedener elektrischer Verbraucher ergeben, zu berücksichtigen. Eine derartige Erscheinung ist mit einer Langzeitdrift zu vergleichen und kann beispielsweise durch Differenzierung der Stromänderungen, beispielsweise auch oder gerade bei definierten Belastungen der Stromleitung erkannt werden.

In der Zeichnung ist ein Ausführungsbeispiel der Erfindung dargestellt. Es zeigt
- Fig. 1: ein Ersatzschaltbild der erfindungsgemäßen Sicherungsvorrichtung
- Fig. 2: eine Einzelheit von Fig. 1.
- Fig. 3-7: konstruktive Ausgestaltungen der Sicherungsvorrichtung von Fig. 1 und 2.
- Fig. 8: eine weitere konstruktive Ausgestaltung der erfindungsgemäßen Sicherungsvorrichtung.
- Fig. 9: eine konstruktive Ausgestaltung einer Batterieklemme mit integrierter Sicherungsvorrichtung
- Fig. 10: ein Diagramm zur weiteren Erläuterung der Erfindung.

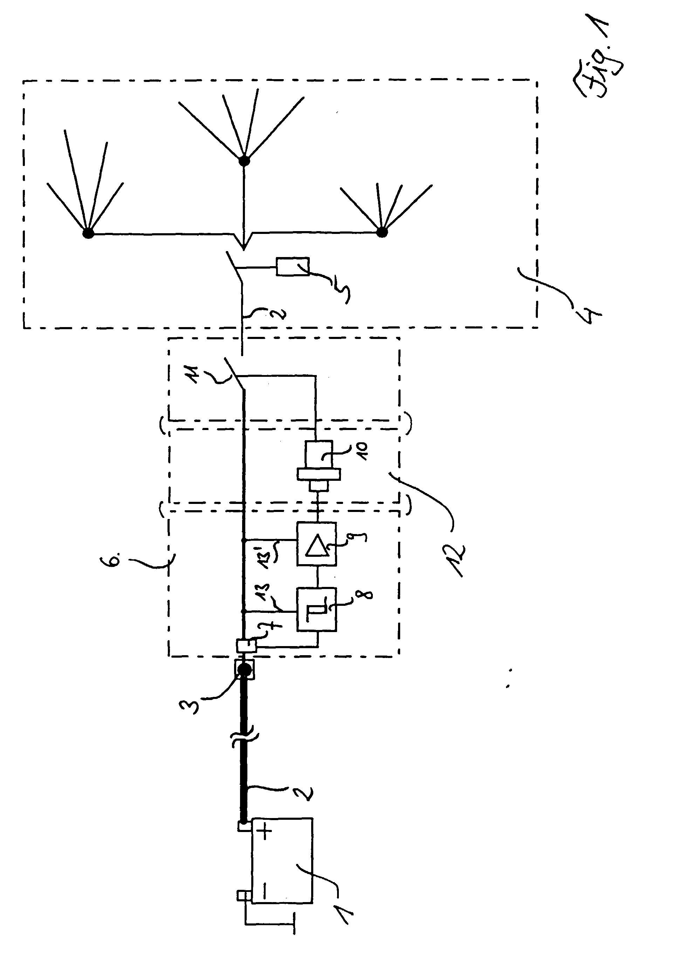

Fig.1 zeigt den Einsatz der erfindungsgemäßen Sicherungsvorrichtung in einem Kraftfahrzeug. Dabei ist eine Batterie 1, eine mit dem Pluspol verbundene Batterieleitung 2, ein Batteriestützpunkt 3 sowie schematisch ein Motorkabelbaum 4 dargestellt, der von der Leitung 2 ausgehend über Neben- und Unterleitungen zu nicht dargestellten elektrischen Verbrauchern führt, die auch durch eine schematische Schalteinrichtung 5 gemeinsam oder individuell zu- bzw. abschaltbar sind.

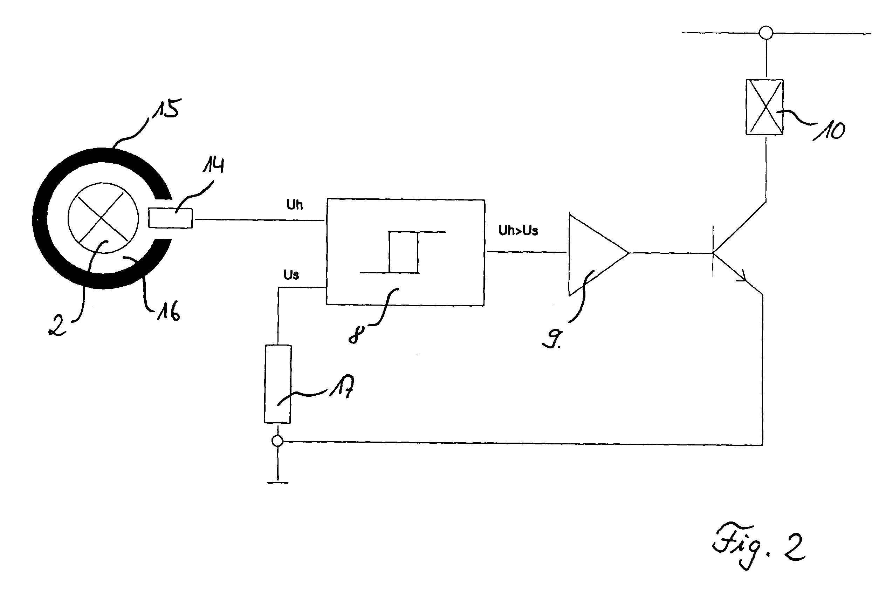

Unmittelbar hinter dem Stützpunkt 3 befindet sich eine Sicherungsvorrichtung 6, die aus einem Stromstärke-Sensor 7 mit nachgeschaltetem Schwellwertschalter 8, einem Verstärker 9 sowie einer Sprengkapsel 10 besteht, die auf ein schematisch dargestelltes Trennmittel 11 wirkt. Die gesamte, schematisch aus den Teilen Elektronik E, Pyrotechnik P und Auslösemechanik A bestehende Vorrichtung ist in einem Gehäuse 12 angeordnet, in dem auch ein Abschnitt der Leitung 2 verläuft. Von dieser gehen schematisch dargestellt auch Versorgungsleitungen 13 und 13' für den Schwellwertschalter 8 und Verstärker 9 ab. Der konstruktive Aufbau des Sensors 7 sowie weitere elektronische Einzelheiten sind in Fig. 2 gezeigt. Der Sensor 7 besteht im wesentlichen aus einem Hallelement 14, das in einem Eisenring 15 sitzt. Dieser umgibt die Leitung 2 und ist demgegenüber durch eine Schicht 16 elektrisch isoliert. Das Hallelement 14 ist über einen Verstärker auf einen Eingang des Schwellwertschalters 8 geführt, der einen weiteren Eingang für die Einstellung der Auslöseschwelle besitzt.

Der Ausgang des Schwellwertschalters 8 steuert einen Verstärker 9, in dessen Stromkreis die Sprengkapsel 10 sitzt. Bei dieser handelt es sich beispielsweise um eine an sich bekannte Zündpille, wie sie üblicherweise bei einem Gurtstraffer verwendet ist.

Zwar ist in Fig. 2 nur eine starre Auslöseschwelle für den Schwellwertschalter 8 dargestellt. Anstelle des hierfür vorgesehenen elektrischen Widerstands 17 konstanten Werts kann dieser auch dynamisch verändert sein, um beispielsweise bei einer betriebsbedingt hohen Strombelastung, beispielsweise beim Anlassen einer nicht dargestellten Brennkraftmaschine ein Zünden der Sprengkapsel 10 zu verhindern. Wie bereits beschrieben, kann diese Einstellung auch vorgenommen werden, um unterschiedliche betriebsbedingte Strombelastungen und/oder vom individuellen Fahrzeug abhängige unterschiedliche Strombelastungen und/oder von der Betriebsdauer oder anderen Einflußfaktoren, wie beispielsweise auch Betriebstemperaturen abhängige betriebsbedingte Änderungen der Strombelastung für die Leitung 2 zu berücksichtigen und die Sprengkapsel 10 nur dann zu zünden, wenn dies aufgrund einer untypisch hohen Strombelastung auf der Leitung 2 erforderlich ist.

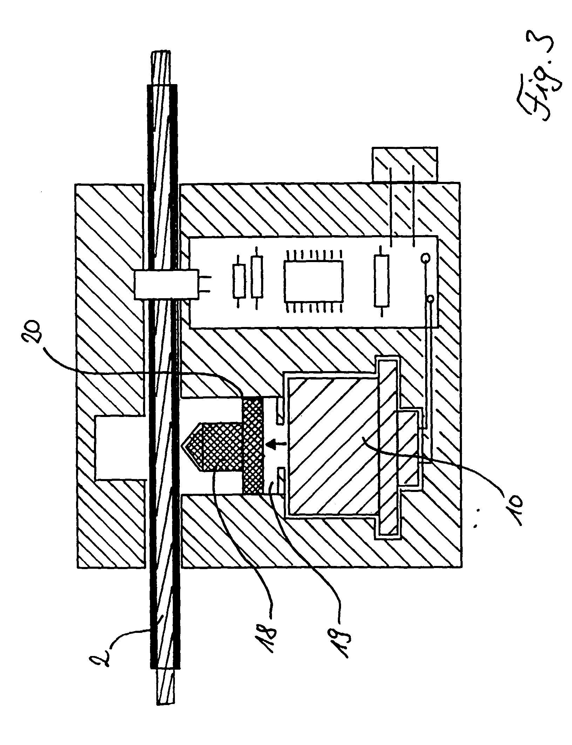

In den Figuren 3 bis 7 sind weitere konstruktive Einzelheiten der Vorrichtung gezeigt.
- In Fig.3: ist eine Ausführungsform für das Gehäuse dargestellt, in dem die Umfänge Elektronik, Pyrotechnik und Auslösemechanik integriert sind. Das Trennmittel ist als Kabelschneide 18 ausgebildet und über einen Luftkanal 19 mit der Sprengkapsel 10 verbunden. Gummilippen 20 halten das Trennmittel 18 an der Leitung 2.

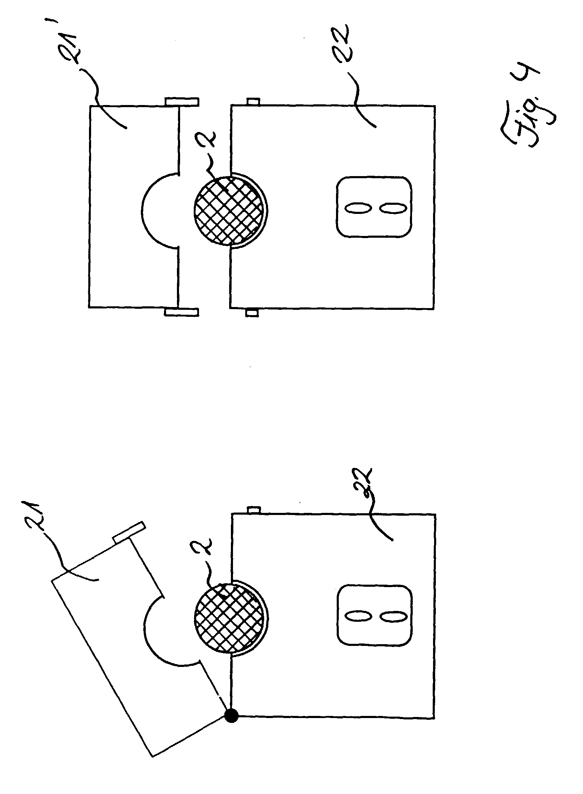

- Fig. 4: zeigt Ausführungsformen für das Gehäuse. Die beiden dargestellten Möglichkeiten besitzen jeweils einen Deckel 21 bzw. 21' der schwenkbar bzw. steckbar auf einem Grundkörper 22 aufsetzbar ist.

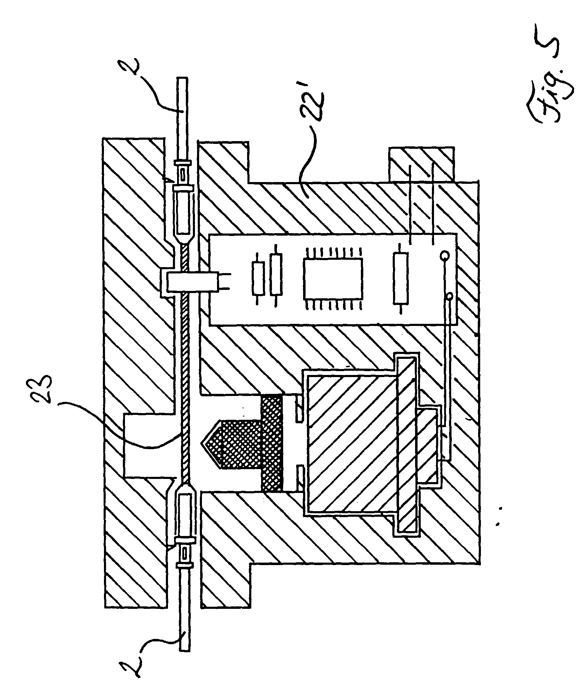

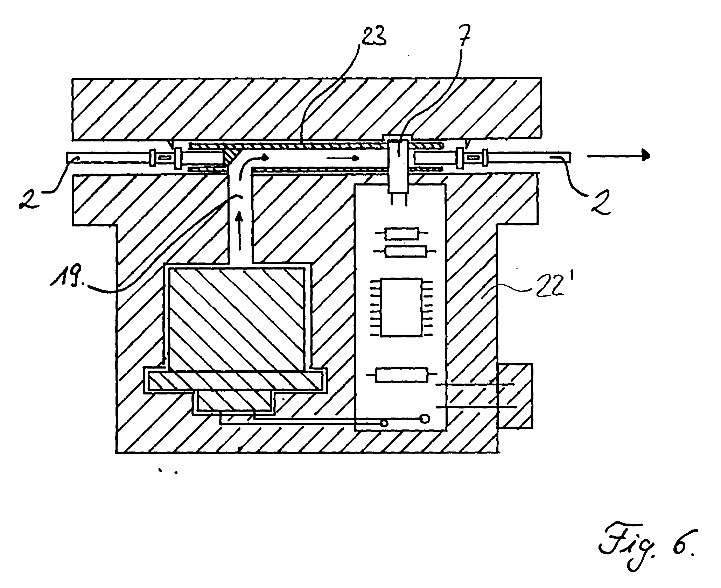

Die Ausführungsformen der Figuren 5 und 6 zeigen innerhalb des Gehäuses 22' jeweils eine Zwischenleitung 23, die beidseitig mit der Leitung 2 elektrisch verbunden ist. Die Leitung 2 ist mit der Zwischenleitung lösbar verbunden und ermöglicht es, im Bedarfsfall ohne aufwendige Reparaturen der Leitung 2 lediglich die Sicherungsvorrichtung auszutauschen. Bei Fig. 6 wird kein Trennmesser eingesetzt, sondern die durch die Zündpille erzeugte Kraft wirkt über den Luftkanal 19 unmittelbar auf eine Stecker, der im Auslösefall aus dem Gehäuse 22' ausgedrückt wird.

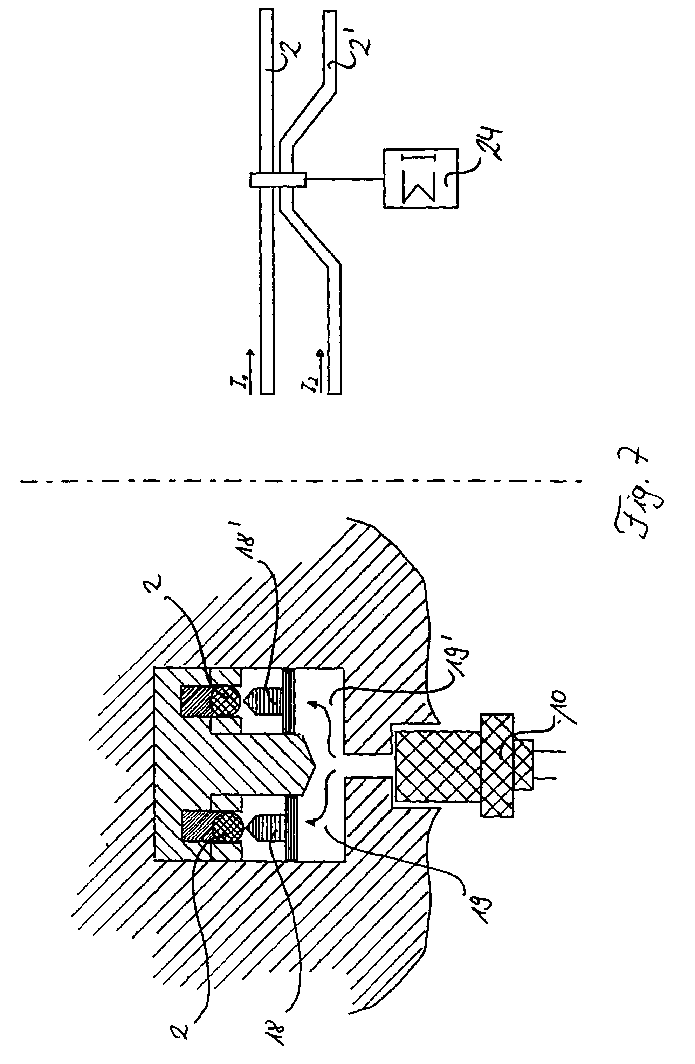

Fig. 7 zeigt die Möglichkeit, daß über eine entsprechende Verästelung der Luftkanäle 19 und 19' mehrere Leitungen gleichzeitig von Trennmitteln 18 und 18' getrennt werden, oder wie hier nicht dargestellt, die Kraft der Zündpille 10 unmittelbar auf mehrere Stecker gleichzeitig wirkt und diese aus einem Gehäuse ausdrückt.

Im weiteren wird die Möglichkeit dargestellt, einen Summenstrom 24 bestehend aus I_{ges}=I₁+I₂+...Iₙ zu messen und als Auslösekriterium zu verwenden.

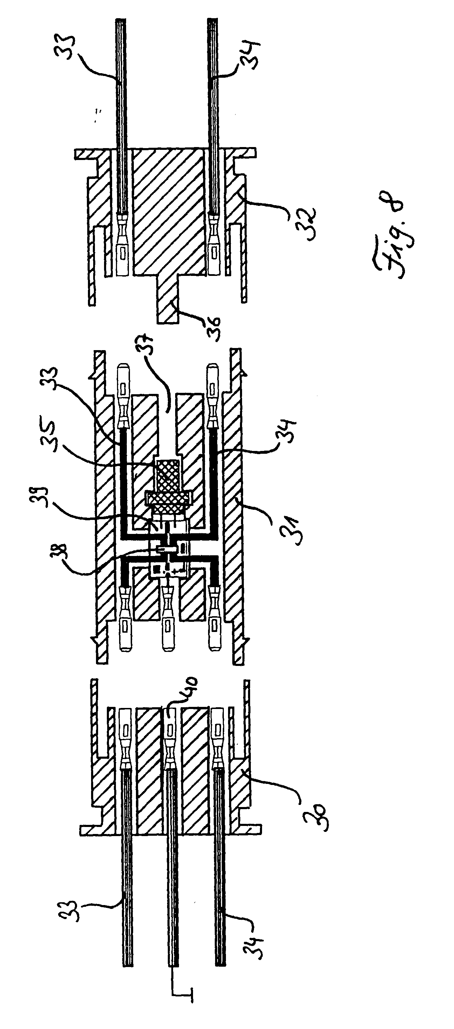

Das in Fig. 8 gezeigte Konstruktionsprinzip zeigt ein aus mehreren Teilen 30, 31 und 32 bestehendes Gehäuse, in dem mehrere Stromleitungen 33 und 34 parallel verlaufen. Die Sprengkapsel 35 wirkt auf einen Ausdrückbolzen 36 der mit dem Gehäuseteil 32 verbunden ist und der im Ruhezustand in einer Druckkammer 37 im Gehäuseteil 31 sitzt. Ein Stromstärkesensor 38 ist mit einer Auswerteschaltung 39 verbunden und den Stromleitungen 33 und 34 zugeordnet. Er mißt den Summenstrom. Übersteigt dieser einen Schwellwert, so wird über einen nachgeschalteten Schwellwertschalter (hier nicht dargestellt) die Sprengkapsel 35 gezündet.

Die Stromversorgung der Auswerteschaltung 39 erfolgt über eine der beiden Stromleitungen 33 oder 34. Der Masseanschluß ist als weiterer Steckkontakt 40 mit der Auswerteschaltung 39 verbunden. Die Gehäuseteile 30 und 31 einerseits und 31 und 32 andererseits sind über nicht im einzelnen bezeichnete Steckkontakte miteinander verbunden.

Wird die Sprengkapsel 35 gezündet, so erzeugt das freiwerdende Gas in der Druckkammer 37 eine entsprechende Kraft und der Ausdrückbolzen 36 wird zusammen mit dem Gehäuseteil 32 aus dem Gehäuseteil 31 gedrückt. Die Stromleitungen 33 und 34 sind unterbrochen.

Im Reperaturfall ist es ohne weiteres möglich, durch Lösen der Steckkontakte das Gehäuseteil 31 zu demontieren und durch ein entsprechendes Teil zu ersetzen. Durch Schließen der Steckkontakte werden die unterbrochenen Stromleitungen 33 bzw. 34 wieder geschlossen. Der hierzu erforderliche Aufwand ist erkennbar gering.

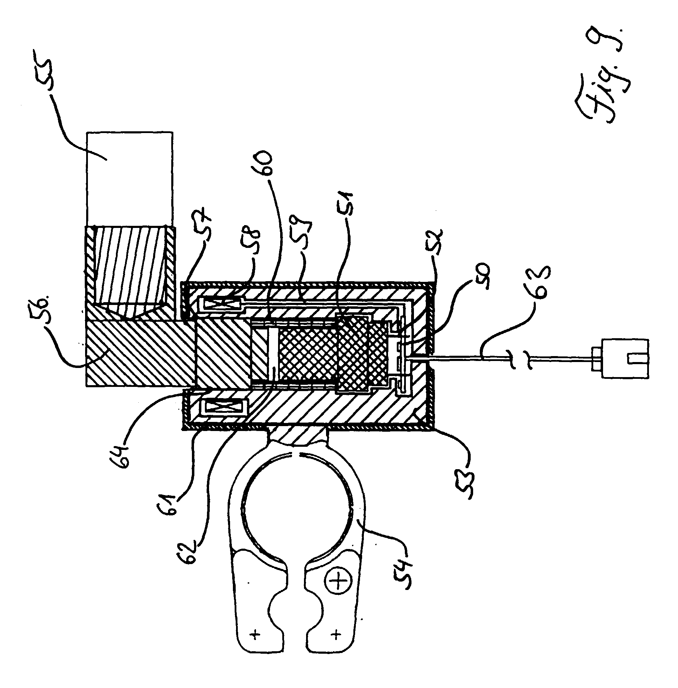

In Fig. 9 wird eine Batterieklemme gezeigt, in der die Pyrotechnik mit der bereits beschriebenen Strommessung und Auslösesteuerung für die Pyrotechnik integriert ist.

Dabei wird die Elektronik (Platine) 50 idealerweise unmittelbar oder über separate Verbindungsleitungen 52 mit der Zündpille/Gasgenerator 51 verbunden und in einem mit der Klemme 54 unmittelbar verbundenen Formteil 53 (Werkstoff: Messing oder Werkstoffe mit ähnlichen elektrischen/mechanischen Eigenschaften) angeordnet. Der Anschluß der Leitung 55 erfolgt über einen entsprechend ausgebildeten Stecker 56, der z.B. mittels Preßpassung 57 mit dem Teil 53 verbunden ist. Im Bereich der Einstecköffnung des Teils 53 ist in das Teil 53 isoliert ein Ferritkern 58 mit Hallelement (nicht dargestellt) zur Stromerfassung integriert. Das Hallelement ist über entsprechende Kontaktschienen oder Leitungen 59 mit der Elektronik 50 verbunden.

Im vorderen Bereich des Steckers 56 ist ein nicht leitendes Kunststoffteil 60 angebracht, das sich im Zustand der Auslösung mit dem Stecker 56 aus dem Teil 53 löst und dabei fest mit dem Stecker 56 in Verbindung bleibt. Bei einem Zurückfedern des Steckers 56 wird eine, unbeabsichtigte Kontaktierung mit der Klemme 54 bzw. Formteil 53 auf diese Weise verhindert.

Eine Kunststoffumspritzung 61 des Teils 53 unterstützt diese Maßnahme zusätzlich.

Wird die Zündpille/Gasmotor 51 aktiviert, so erzeugt das freiwerdende Gas in Vorvolumen 62, das zwischen Zündpille 51 und Stecker 56 vorgesehen ist, eine entsprechende Kraft und der Stecker 56 wird aus dem mit der Klemme 54 einstückig verbundenen, elektrisch leitenden Formteil 53 gedrückt. Die Stromleitung 55 ist unterbrochen.

Die Spannungsversorgung für die Elektronik erfolgt Plusseitig direkt von der Klemme; Masse wird über einen eigenen Anschluß 63 zugeführt.

Die elektrische Kontaktierung des Steckers 56 mit dem erweiterten Batterieklemmenbauteil 53 erfolgt vorzugsweise im Bereich 64 der hier dargestellten Preßpassung.

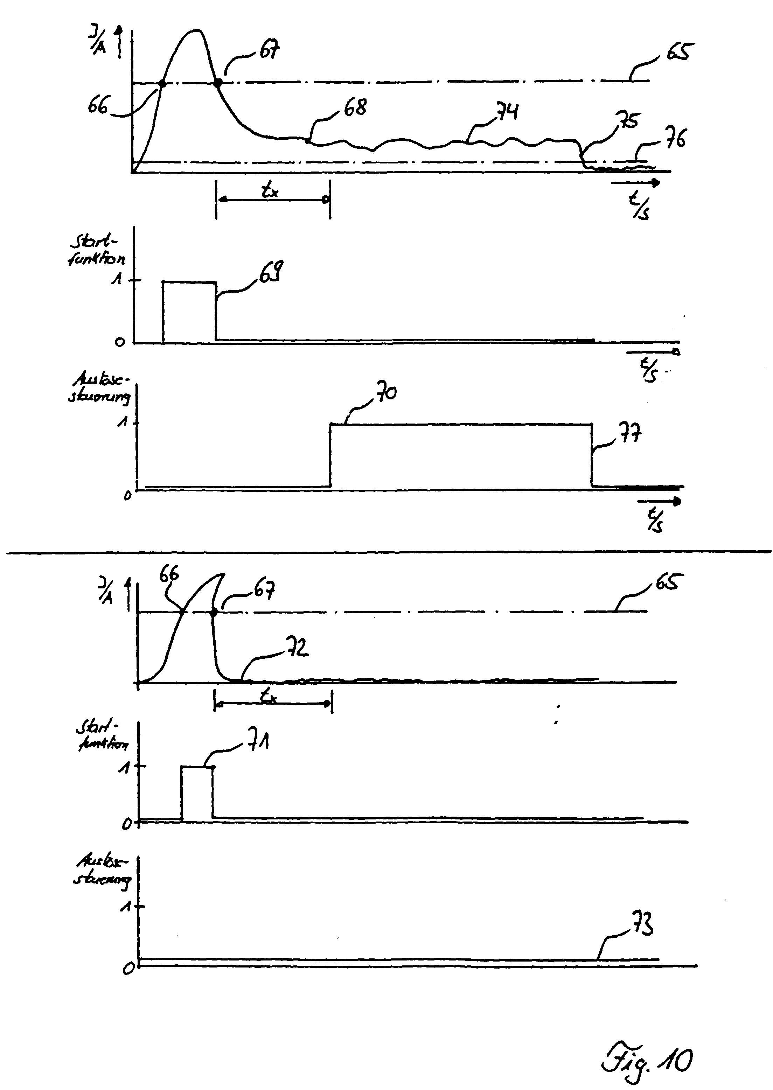

Fig. 10 zeigt einen möglichen Auslösealgorithmus für den Fall, das es sinnvoll ist, den Startstrom bei Inbetriebnahme des Fahrzeugs auszublenden und die Sicherungsüberwachung (Strommessung) erst nach erfolgtem Motorstart zu aktivieren.

Um während des Startvorganges nicht fälschlicherweise den Startstrom als Auslösekriterium zu verwenden, kann über die KL50-Erkennung die Meßtechnik während des Startvorganges ausgeschalten werden. Diese Möglichkeit hat den Nachteil, daß ein KL50-Signal vom Motorraum bis u.U. in den Kofferraum verkabelt werden muß.

Eine weitere Alternative ist die Festlegung einer Triggerschwelle, die den Meßvorgang aktiviert, d.h. die Auslösesteuerung nach dem Start schärft.

Gezeigt wird diese Vorgehensweise in der Fig. 10. Beim Startvorgang fließt ein Strom der über einer in der Elektronik eingestellten Schwelle 65 liegt. Wird diese überschritten (66) und anschließend unterschritten (67) und ist der darauf folgende Stromfluß (68) verschieden von Null ist der Startvorgang (69) beendet und die Auslösesteuerung (70) aktiviert. (Die Stromrichtung spielt dabei keine Rolle).

Wird ein Startvorgang (71) abgebrochen ist auf der Leitung zu Starter augenblicklich kein Stromfluß (72) mehr feststellbar, die Auslösesteuerung (73) wird in diesem Falle gesperrt.

Im Betriebsfalle (74) des Fahrzeugs fließt dagegen ständig ein Strom vom Generator in die Batterie und/oder ins Bordnetz. Dieser Strom wird deutlich unterschiedlich zu Null sein. Nach Abstellen des Fahrzeugs (75) wird der Stromfluß auf der Leitung zwischen Batterie und Starter/Generator zu Null werden. Diesen Vorgang erkennt die Elektronik über eine Min.-schwelle (76) und schaltet die Stromerfassung während des Fahrzeugstillstandes 77 ab.

## Patentansprüche

1. Sicherungsvorrichtung für eine Stromleitung (2) in Fahrzeugen, mit einem Stromstärke-Sensor (7) mit nachgeschalteter Auswerteschaltung (8, 9) und mit einem Trennmittel (11) für die Stromleitung (2) bei einer über einem Grenzwert liegender Stromstärke, dadurch gekennzeichnet, daß der Sensor (7), die Auswerteschaltung (8, 9) und das Trennmittel (11) in einem Gehäuse (12) angeordnet sind, in dem auch ein Abschnitt der Stromleitung (2) verläuft.

2. Sicherungsvorrichtung nach Anspruch 1, dadurch gekennzeichnet, daß die Auswerteschaltung (8, 9) über die Stromleitung (2) mit Betriebsspannung versorgt ist.

3. Sicherungsvorrichtung nach Anspruch 1 oder 2, dadurch gekennzeichnet, daß die Stromleitung (2) beidseitig reversibel vom Gehäuse lösbar ist.

4. Sicherungsvorrichtung nach Anspruch 3, dadurch gekennzeichnet, daß das Gehäuse (12) zweigeteilt ist und daß die beiden Gehäuseteile (21, 22) durch das Trennmittel voneinander lösbar sind.

5. Sicherungsvorrichtung nach Anspruch 3 oder 4, dadurch gekennzeichnet, daß im Gehäuse mehrere Stromleitungen verlaufen, die gleichzeitig durch das Trennmittel (11) voneinander lösbar lösbar sind.

6. Sicherungsvorrichtung nach Anspruch 5, dadurch gekennzeichnet, daß der Stromsensor (7) gleichzeitig den Strom in den Stromleitungen mißt und der Grenzwert auf die in einer der oder über alle Stromleitungen liegenden Stromstärke bezogen ist.

7. Sicherungsvorrichtung nach Anspruch 1 oder 2, dadurch gekennzeichnet, daß die Stromleitung (2) beidseitig mit einer Zwischenleitung elektrisch verbunden ist, auf die das Trennmittel (11) wirkt.

8. Sicherungsvorrichtung nach einem der Ansprüche 1 bis 7, dadurch gekennzeichnet, daß der Auswerteschaltung (8, 9) zusätzlich ein Blockiersignal zugeführt ist.

9. Sicherungsvorrichtung nach einem der Ansprüche 1 bis 8, dadurch gekennzeichnet, daß der Grenzwert an betriebsbedingt veränderliche Stromstärkewerte der Stromleitung (2) anpaßbar ist.

10. Sicherheitsvorrichtung nach Anspruch 1, dadurch gekennzeichnet, daß das Gehäuse (12) unmittelbar in eine Batterieklemme integriert ist.

## Claims

1. A safety device for a circuit (2) in vehicles comprising a current strength sensor (7) with a downstream evaluating circuit (8, 9) and a means (11) for isolating the circuit (2) if the current rises above a critical value, characterised in that the sensor (7), the evaluating circuit (8, 9) and the isolating means (11) are disposed in a casing (12) in which a portion of the circuit (2) also extends.

2. A safety device according to claim 1, characterised in that the evaluating circuit (8, 9) is supplied with the operating voltage via the circuit (2).

3. A safety device according to claim 1 or 2, characterised in that the circuit (2) is reversibly releasable from the casing on both sides.

4. A safety device according to claim 3, characterised in that the casing (12) is in two parts and the two parts (21, 22) are releasable from one another by the isolating means.

5. A safety device according to claim 3 or 4, characterised in that a number of circuits extend in the casing and can be simultaneously separated from one another by the isolating means (11).

6. A safety device according to claim 5, characterised in that the current sensor (7) simultaneously measures the current in the circuits and the limiting value is related to the intensity of the current in one or all the circuits.

7. A safety device according to claim 1 or 2, characterised in that the current (2) is electrically connected at both sides to an intermediate line on which the isolating means (11) acts.

8. A safety device according to any of claims 1 to 7, characterised in that the evaluating circuit (8, 9) is also supplied with a blocking signal.

9. A safety device according to any of claims 1 to 8, characterised in that the limiting value is adaptable to variations in the intensity of the current in the circuit (2), depending on operating conditions.

10. A safety device according to claim 10, characterised in that the casing (12) is directly incorporated in a battery terminal.

## Revendications

1. Dispositif de sécurité pour une ligne électrique (2) de véhicule automobile comprenant un circuit d'exploitation (8, 9) en aval d'un capteur (7) d'intensité électrique et un moyen de coupure (11) de la ligne électrique (2) en cas d'intensité de courant dépassant un seuil,
caractérisé en ce que
le capteur (7), le circuit d'exploitation (8, 9) et le moyen de coupure (11) sont logés dans un boîtier (12) dans lequel passe une partie de la ligne électrique (2).

2. Dispositif de sécurité selon la revendication 1,
caractérisé en ce que
le circuit d'exploitation (8, 9) est alimenté en tension de fonctionnement par la ligne électrique (2).

3. Dispositif selon la revendication 1 ou 2,
caractérisé en ce que
la ligne électrique (2) se détache de manière réversible du boîtier aux deux extrémités.

4. Dispositif selon la revendication 3,
caractérisé en ce que
le boîtier (12) est divisé en deux parties et les deux parties de boîtier (21, 22) peuvent être séparées l'une de l'autre par le moyen de coupure.

5. Dispositif selon la revendication 3 ou 4,
caractérisé en ce que
le boîtier est traversé par plusieurs câbles électriques qui peuvent être ouverts simultanément l'un par rapport à l'autre par le moyen de coupure (11).

6. Dispositif selon la revendication 5,
caractérisé en ce que
le capteur de courant (7) mesure en même temps l'intensité dans les lignes électriques et la valeur limite est rapportée à une intensité de courant dans l'une ou dans toutes les lignes électriques.

7. Dispositif selon la revendication 1 ou 2,
caractérisé en ce que
la ligne électrique (2) est relié aux deux extrémités, électriquement à une ligne intermédiaire sur laquelle agit le moyen de coupure (11).

8. Dispositif selon l'une des revendications 1 à 7,
caractérisé en ce que
le circuit d'exploitation (8, 9) reçoit en outre un signal de blocage.

9. Dispositif selon l'une des revendications 1 à 8,
caractérisé en ce que
la valeur limite des intensités de courant variables du fait du fonctionnement peut être adaptée à la ligne électrique (2).

10. Dispositif selon la revendication 1,
caractérisé en ce que
le boîtier (12) est intégré directement dans une borne de la batterie.
